# EUROPÄISCHE PATENTSCHRIFT

(11) **EP 3 750 191 B1**
(45) Veröffentlichungstag und Bekanntmachung des Hinweises auf die Patenterteilung: **11.09.2024**
(21) Anmeldenummer: 19718056.5
(22) Anmeldetag: 05.02.2019
(51) Int. Cl.: H01L 31/0224, H01L 31/068

(54) **VERFAHREN ZUR VERBESSERUNG DES OHMSCHEN KONTAKTVERHALTENS ZWISCHEN EINEM KONTAKTGITTER UND EINER EMITTERSCHICHT EINER SILIZIUMSOLARZELLE**
METHOD FOR IMPROVING THE OHMIC CONTACT BEHAVIOR BETWEEN A CONTACT GRID AND AN EMITTER LAYER OF A SILICON SOLAR CELL
PROCÉDÉ D'AMÉLIORATION DU COMPORTEMENT DE CONTACT OHMIQUE ENTRE UNE GRILLE DE CONTACT ET UNE COUCHE D'ÉMETTEUR D'UNE CELLULE SOLAIRE EN SILICIUM

(30) Priorität: 07.02.2018 DE 102018001057
(43) Veröffentlichungstag der Anmeldung: 16.12.2020
(73) Patentinhaber: CE Cell Engineering GmbH, 06184 Kabelsketal (DE)
(72) Erfinder: ZHAO, Hongming, 06110 Halle/Saale (DE)
(74) Vertreter: Findeisen Neumann Scheit Partnerschaft mbB
(86) Internationale Anmeldenummer: PCT/DE2019/000027
(87) Internationale Veröffentlichungsnummer: WO 2019/154450

(56) Entgegenhaltungen:
- EP-A1- 2 164 114
- EP-B1- 3 494 601

## Beschreibung

Die Erfindung betrifft ein Verfahren zur Verbesserung des ohmschen Kontaktverhaltens zwischen einem Kontaktgitter und einer Emitterschicht einer Siliziumsolarzelle.

Zur Kontaktierung kristalliner Siliziumsolarzellen wird auf deren mit dielektrischem Siliziumnitrid beschichtete Frontseite eine Metallpaste in Form eines Kontaktgitters im Siebdruckverfahren aufgetragen. Nach dem Auftragen wird die Metallpaste bei 800 - 900 °C in das Siliziumnitrid eingebrannt und damit ein elektrischer Kontakt zur Emitterschicht formiert. Die Prozessführung beim Einbrennen der Metallpaste hat dabei einen entscheidenden Einfluss auf die Kontaktausbildung, wobei eine fehlerhafte Prozessführung zu hohen Kontaktwiderständen am Übergang zwischen Metallpaste und Emitterschicht der Siliziumsolarzelle führt. Hohe Kontaktwiderstände können dann in einem reduzierten Wirkungsgrad der Siliziumsolarzelle resultieren.

Aus dem Stand der Technik sind Verfahren bekannt, die eine Wirkungsgradstabilisierung oder Leistungsverbesserung von Solarzellen ermöglichen. So beschreibt DE 10 2011 056 843 A1 ein Verfahren zur "Stabilisierung eines Wirkungsgrades von Siliziumsolarzellen". Hierbei wird während des Laminierprozesses ein kontinuierlicher Stromfluss in einen Solarzellenverbund eingeprägt, wodurch im Wesentlichen Bor-Sauerstoff-Komplexe im Siliziummaterial rückgebildet werden. Mit der Wirkungsgradstabilisierung oder Leistungsverbesserung beschäftigt sich auch die Druckschrift EP 2 164 114 A1.

In US 4 166 918 A wird ein Verfahren zur Leistungsverbesserung einer Solarzelle vorgeschlagen, wobei die Solarzelle mit einer entgegen ihrer Vorwärtsrichtung angelegten Spannung beaufschlagt wird. Dabei wird ein Stromfluss entlang von Kurzschlüssen innerhalb der Solarzelle angeregt, wodurch diese "ausgebrannt" und damit eliminiert werden.

Ein Einfluss dieser bekannten Verfahren auf den Übergang zwischen Kontaktgitter und Emitterschicht einer Siliziumsolarzelle ist allerdings nicht bekannt.

Zur Erzeugung niederohmiger elektrischer Kontakte zur Emitterschicht sind niedrige Schichtwiderstände (unter 100 Ohm/sq) in der Emitterschicht nötig. Dies führt allerdings zu einer schlechten Konversion kurzwelligen Lichtes in elektrischen Strom. Eine bessere Konversion wird bei Schichtwiderständen im Bereich von 110-150 Ohm/sq erreicht. Hier können mit den üblichen Einbrennprozessen aber nur verhältnismäßig hochohmige Übergänge zwischen Kontaktgitter und Emitterschicht erzeugt werden. Zur Umgehung wurde hierfür das Konzept des selektiven Emitters entwickelt (z.B. EP 2 583 315 B1). Hierbei werden die Bereiche der Emitterschicht, welche später mit der Metallpaste bedruckt werden, lokal höher dotiert, sodass der Schichtwiderstand lokal abgesenkt wird. Dies verlangt allerdings aufwändige Zusatzschritte im Herstellungsprozess der Siliziumsolarzellen.

Aus dem Bereich elektronischer Bauelemente ist es aus DD 250 247 A3 bekannt, dass das ohmsche Kontaktverhalten zu Halbleiterkörpern, die mittels elektrisch leitfähigem Klebestoff kontaktiert wurden, durch Anlegen eines Spannungspulses verbessert werden kann. Der Wirkmechanismus der Kontaktverbesserung wird in der Schrift nicht näher beschrieben. Die bei der Kontaktierung verwendeten elektrisch leitfähigen Klebstoffe bestehen im Wesentlichen aus elektrisch leitfähigen Partikeln, meist Silberkugeln oder Silberflakes, die von einer Polymermatrix umgeben sind.

In der europäischen Patentanmeldung EP 3 494 601 A1 wird ein Verfahren zur Verbesserung des ohmschen Kontaktverhaltens zwischen einem Kontaktgitter und einer Emitterschicht einer Siliziumsolarzelle vorgeschlagen. Hierbei wird das Kontaktgitter einer Siliziumsolarzelle mit einer Kontaktstift-Matrix kontaktiert und zwischen dieser und dem Rückkontakt dieser Solarzelle über Spannungspulse ein Stromfluss generiert. Bei Pulsdauern zwischen 1 ms bis 100 ms und induzierten Stromstärken im Bereich der 10- bis 30-fachen Kurzschlussstromstärke der Siliziumsolarzelle kann damit ein hoher Kontaktwiderstand zwischen dem Kontaktgitter und der Emitterschicht gesenkt werden und somit beispielsweise eine fehlerhafte Prozessführung beim Einbrennen der Metallpaste korrigiert werden. Alternativ wird ein Verfahren beschrieben, bei dem eine elektrisch vorgespannte Siliziumsolarzelle mit einer Punktlichtquelle abgerastert wird, wobei in einem beleuchteten Teilbereich ein Stromfluss mit einer 10- bis 30-fachen Kurzschlussstromdichte der Siliziumsolarzelle erzeugt wird. Je nach Typ und Qualität der Siliziumsolarzelle kann hier unter bestimmten Konstellationen durch die Bestrahlung der sonnenzugewandten Seite der Siliziumsolarzelle eine ungewollte Materialbeeinflussung bis hin zur Materialschädigung hervorgerufen werden. Aufgabe der Erfindung ist es, das Verfahren zur Verbesserung des ohmschen Kontaktverhaltens zwischen einem Kontaktgitter und einer Emitterschicht einer Siliziumsolarzelle dahingehend weiterzubilden, dass die durch Bestrahlung der sonnenzugewandten Seite verursachten Materialbeeinflussungen weiter minimiert werden. Darüber hinaus soll das Verfahren auch bei Siliziumsolarzellen anwendbar sein, deren Emitterschicht einen hohen Schichtwiderstand aufweist.

Diese Aufgabe wird durch den Gegenstand des Anspruchs 1 gelöst, indem zunächst eine Siliziumsolarzelle mit einer Emitterschicht einem Kontaktgitter und einem Rückkontakt bereitgestellt wird und das Kontaktgitter mit einem Pol einer Spannungsquelle elektrisch verbunden wird. Der andere Pol der Spannungsquelle wird elektrisch mit einer Kontaktiereinrichtung verbunden, die auf dem Rückkontakt aufgesetzt wird. Mit der Spannungsquelle wird dann eine entgegen der Vorwärtsrichtung der Siliziumsolarzelle gerichtete Spannung, die betragsmäßig geringer als die Durchbruchsspannung der Siliziumsolarzelle ist, angelegt. Beim Anliegen dieser Spannung wird nun eine Punktlichtquelle über die sonnenzugewandte Seite der Siliziumsolarzelle geführt und dabei ein Ausschnitt eines Teilbereichs der sonnenzugewandten Seite beleuchtet. Damit wird in dem Teilbereich ein Stromfluss induziert, der bezogen auf den Ausschnitt eine Stromdichte von 200 A/cm² bis 20.000 A/cm² hat und für 10 ns bis 10 ms auf den Teilbereich einwirkt, ausgenommen eine Stromdichte resultierend aus einem Stromfluss im Bereich von 100 mA und einer Laserspotgröße von 60 µm bei einer Einwirkungszeit resultierend aus einem Laservorschub von 10 m/s

Mit dem erfindungsgemäßen Verfahren werden fehlerhafte Prozessführungen beim Einbrennen der Metallpaste ausgeglichen, sodass die Solarzellen dennoch den für ihren Aufbau optimalen Serienwiderstand erreichen. Darüber hinaus wird mit dem erfindungsgemäßen Verfahren auch bei Emitterschichten mit hohen Schichtwiderständen ein sehr gutes ohmsches Kontaktverhalten zwischen dem Kontaktgitter und der Emitterschicht erreicht, sodass die zum Ausbilden eines selektiven Emitters nötigen Prozessschritte entfallen können. Ferner kann durch Anwendung des erfindungsgemäßen Verfahrens auch der Einbrennprozess bei niedrigeren Temperaturen ausgeführt und damit Energie im Herstellungsprozess der Siliziumsolarzelle gespart werden.

Es wird vorgeschlagen, dass die Punktlichtquelle ein Laser, eine Leuchtdiode oder eine Blitzlampe ist.

In einer Ausgestaltung weist die Punktlichtquelle auf dem Ausschnitt eine Leistungsdichte von 500 W/cm² bis 200.000 W/cm² auf.

Eine Ausführung sieht vor, dass die Punktlichquelle eine Strahlung mit einer Wellenlänge im Bereich von 400 nm bis 1500 nm emittiert.

In einer weiteren Ausgestaltung hat der Ausschnitt eine Fläche im Bereich von 1·10³ µm² bis 1·10⁴ µm².

Es wird vorgeschlagen, dass die entgegen der Vorwärtsrichtung der Siliziumsolarzelle gerichtete Spannung im Bereich von 1 V bis 20 V liegt.

Es wird weiterhin vorgeschlagen, dass die Punktlichtquelle direkt neben Kontaktfingern des Kontakgitters über die sonnenzugewandte Seite der Siliziumsolarzelle geführt wird.

In einer Ausführung ist die Siliziumsolarzelle monofacial oder bifacial ausgebildet.

In einer weiteren Ausführung weist die Siliziumsolarzelle ein n- oder p-dotiertes Siliziumsubstrat auf.

Eine Ausgestaltung sieht vor, dass die Emitterschicht einen Schichtwiderstand von über 100 Ohm/sq aufweist.

Nachfolgend werden Ausführungsbeispiele der Erfindung erläutert.

Zunächst wird eine kristalline Siliziumsolarzelle bereitgestellt. Diese weist auf ihrer sonnenzugewandten Seite eine Antireflexschicht aus Siliziumnitrid auf. Unterhalb dieser Antireflexschicht ist eine Emitterschicht der Siliziumsolarzelle angeordnet. Auf der sonnenzugewandten Seite ist eine Frontmetallisierung in Form eines Kontaktgitters aus Kontaktfingern und Sammelkontakten (Busbars) aus einer marktüblichen Metallpaste (z.B. Silberpaste) aufgedruckt, welche entsprechend den Herstellervorgaben ausgehärtet und in die Siliziumnitridschicht eingebrannt wurde. Auf der sonnenabgewandten Seite ist die Siliziumsolarzelle mit einem Rückkontakt ausgestattet. Dieser Rückkontakt besteht aus einer metallischen Schicht, die entweder mit (PERC-Konzept) oder ohne Passivierung ausgeführt sein kann.

Das Kontaktgitter wird mit einem Pol einer Spannungsquelle elektrisch verbunden. Am anderen Pol der Spannungsquelle wird eine Kontaktiereinrichtung angeschlossen, die mit dem Rückkontakt verbunden wird. Mit der Spannungsquelle wird dann eine entgegen der Vorwärtsrichtung der Siliziumsolarzelle gerichtete Spannung, die betragsmäßig geringer ist als die Durchbruchsspannung der Siliziumsolarzelle, angelegt. Beim Anliegen dieser Spannung wird nun eine Punktlichtquelle über die sonnenzugewandte Seite der Siliziumsolarzelle geführt. Die Punktlichtquelle kann beispielsweise ein Laser, eine Leuchtdiode oder auch die fokussierte Strahlung einer Blitzlampe sein. Die Erfindung ist aber nicht auf diese Strahlungsquellen beschränkt. Die Punktlichtquelle emittiert Strahlung mit Wellenlängen im Bereich von 400 nm bis 1500 nm. Von dieser Punktlichtquelle wird ein Ausschnitt eines Teilbereichs der sonnenzugewandten Seite der Siliziumsolarzelle beleuchtet, wodurch ein Stromfluss in dem Teilbereich induziert wird. Der Stromfluss hat bezogen auf den Ausschnitt eine Stromdichte von 200 A/cm² bis 20.000 A/cm² und wirkt für 10 ns bis 10 ms auf den Teilbereich ein, ausgenommen eine Stromdichte resultierend aus einem Stromfluss im Bereich von 100 mA und einer Laserspotgröße von 60 µm bei einer Einwirkungszeit resultierend aus einem Laservorschub von 10 m/s.

Die für die Verbesserung des ohmschen Kontaktverhaltens zwischen dem Kontaktgitter und der Emitterschicht nötigen hohen Stromdichten können insbesondere durch das Verschieben des Arbeitspunktes des beleuchteten Zellbereichs erreicht werden, ohne dass eine strahlungsgenerierte Materialschädigung hervorgerufen wird. Im Zusammenspiel zwischen der Strahlungsdichte der Strahlungsquelle auf dem Ausschnitt, der Einwirkzeit und der angelegten Spannung werden die nötigen Stromdichten erreicht, ohne dass eine materialschädigende Bestrahlung nötig ist. Bei einem bestrahlten Ausschnitt, dessen Fläche einen Durchmesser von etwa 60 µm aufweist, werden bei einer angelegten Spannung von 10 V üblicherweise Ströme mit einer Stärke von 50 mA bis 600 mA erzeugt, sodass bezogen auf die Fläche des bestrahlten Ausschnitts eine Stromdichte in der Größenordnung 200 A/cm² bis 20.000 A/cm² wirkt, ausgenommen eine Stromdichte resultierend aus einem Stromfluss im Bereich von 100 mA und einer Laserspotgröße von 60 µm bei einer Einwirkungszeit resultierend aus einem Laservorschub von 10 m/s. Die absolut fließenden Ströme werden insbesondere durch die verhältnismäßig kleine Fläche des bestrahlten Ausschnitts gering gehalten.

Grundsätzlich ist es beim Abrastern der sonnenzugewandten Seite der Siliziumsolarzelle ausreichend, dass die Punktlichtquelle direkt links und rechts neben den Kontaktfingern entlanggefahren wird. Damit liegen die Prozesszeiten für die Bearbeitung einer 6"-Zelle mit dem erfindungsgemäßen Verfahren in der Größenordnung von einer Sekunde.

In einem weiteren Ausführungsbeispiel werden Siliziumsolarzellen mit dem erfindungsgemäßen Verfahren behandelt, deren Kontaktgitter bei einer geringeren Temperatur als der vom Hersteller der Metallpaste empfohlenen Temperatur eingebrannt wurde. Üblicherweise erfolgt das Einbrennen bei Temperaturen im Bereich von 800 °C. Wird die Metallpaste nur bei einer Temperatur von beispielsweise 700 °C eingebrannt, so weisen die Siliziumsolarzellen am Übergang zwischen Kontaktgitter und Emitterschicht einen hohen Kontaktwiderstand auf. Auch bei derartigen Siliziumsolarzellen wird mit dem erfindungsgemäßen Verfahren eine Verbesserung des ohmschen Kontaktverhaltens zwischen dem Kontaktgitter und der Emitterschicht erreicht. Werden das erfindungsgemäße Verfahren und ein mit niedrigeren Temperaturen geführter Einbrennprozess kombiniert, werden bei gleichzeitiger Energieeinsparung dieselben Kontaktwiderstände am Übergang zwischen Kontaktgitter und Emitterschicht erreicht.

Das erfindungsgemäße Verfahren ist sowohl bei monofacialen, als auch bei bifacialen Siliziumsolarzellen anwendbar. Bei letzteren ist eine einseitige Behandlung ausreichend um die Kontakte auf beiden Seiten zu optimieren.

Bei einem weiteren Ausführungsbeispiel werden Siliziumsolarzellen behandelt, deren Emitterschicht nicht selektiv ausgebildet ist und damit vollflächig einen hohen Schichtwiderstand (über 100 Ohm/sq) aufweist. Wie oben beschrieben werden auch diese Siliziumsolarzellen mit der Metallpaste bedruckt und anschließend einem Einbrennprozess unterzogen, wobei auch hier der Einbrennprozess gemäß Herstellerangaben oder bei niedrigeren Temperaturen ausgeführt werden kann. Nach dem Einbrennprozess weisen die Siliziumsolarzellen am Übergang zwischen Kontaktgitter und Emitterschicht nur einen vergleichsweise hochohmigen Kontaktwiderstand auf. Mit der Anwendung des erfindungsgemäßen Verfahrens wird auch bei diesen Siliziumsolarzellen durch das Zusammenspiel von der Strahlungsdichte der Strahlungsquelle auf dem Ausschnitt, der Einwirkzeit und der angelegten Spannung der Kontaktwiderstand gesenkt und der für den optimalen Betrieb der Siliziumsolarzelle nötigen Wert reduziert. Ein selektiver Emitter ist damit nicht nötig, sodass die aufwendigen Schritte für dessen Herstellung entfallen können.

## Patentansprüche

1. Verfahren zur Verbesserung des ohmschen Kontaktverhaltens zwischen einem Kontaktgitter und einer Emitterschicht einer Siliziumsolarzelle, **dadurch gekennzeichnet, dass** zunächst die Siliziumsolarzelle mit der Emitterschicht, dem Kontaktgitter und einem Rückkontakt bereitgestellt wird und dass das Kontaktgitter mit einem Pol einer Spannungsquelle elektrisch verbunden wird und dass eine mit dem anderen Pol der Spannungsquelle elektrisch verbundene Kontaktiereinrichtung mit dem Rückkontakt verbunden wird und dass mit der Spannungsquelle eine entgegen der Vorwärtsrichtung der Siliziumsolarzelle gerichtete Spannung, die betragsmäßig geringer ist als die Durchbruchsspannung der Siliziumsolarzelle, angelegt wird und dass beim Anliegen dieser Spannung eine Punktlichtquelle über die sonnenzugewandte Seite der Siliziumsolarzelle geführt wird und dabei ein Ausschnitt eines Teilbereichs der sonnenzugewandten Seite beleuchtet wird und dass damit ein Stromfluss in dem Teilbereich induziert wird und dass dieser Stromfluss bezogen auf den Ausschnitt eine Stromdichte von 200 A/cm² bis 20.000 A/cm² hat und für 10 ns bis 10 ms auf den Teilbereich einwirkt, ausgenommen eine Stromdichte resultierend aus einem Stromfluss im Bereich von 100 mA und einer Laserspotgröße von 60 µm bei einer Einwirkungszeit resultierend aus einem Laservorschub von 10 m/s

2. Verfahren nach Anspruch 1, **dadurch gekennzeichnet,**
**dass** die Punktlichtquelle ein Laser, eine Leuchtdiode oder eine Blitzlampe ist.

3. Verfahren nach Anspruch 1, **dadurch gekennzeichnet,**
**dass** die Punktlichtquelle auf dem Ausschnitt eine Leistungsdichte von 500 W/cm² bis 200.000 W/cm² aufweist.

4. Verfahren nach Anspruch 1, **dadurch gekennzeichnet,**
**dass** die Punktlichquelle eine Strahlung mit einer Wellenlänge im Bereich von 400 nm bis 1500 nm emittiert.

5. Verfahren nach Anspruch 1, **dadurch gekennzeichnet,**
**dass** der Ausschnitt eine Fläche im Bereich von 1·10³ µm² bis 1·10⁴ µm² hat.

6. Verfahren nach Anspruch 1, **dadurch gekennzeichnet,**
**dass** die entgegen der Vorwärtsrichtung der Siliziumsolarzelle gerichtete Spannung im Bereich von 1 V bis 20 V liegt.

7. Verfahren nach Anspruch 1, **dadurch gekennzeichnet,**
**dass** die Punktlichtquelle direkt neben Kontaktfingern des Kontakgitters über die sonnenzugewandte Seite der Siliziumsolarzelle geführt wird.

8. Verfahren nach Anspruch 1, **dadurch gekennzeichnet,**
**dass** die Siliziumsolarzelle monofacial oder bifacial ausgebildet ist

9. Verfahren nach Anspruch 1, **dadurch gekennzeichnet,**
**dass** die Siliziumsolarzelle ein n- oder p-dotiertes Siliziumsubstrat aufweist.

10. Verfahren nach Anspruch 1, **dadurch gekennzeichnet,**
**dass** die Emitterschicht einen Schichtwiderstand von über 100 Ohm/sq aufweist.

## Claims

1. Method for improving the ohmic-contact behaviour between a contact grid and an emitter layer in a silicon solar cell, **characterized in that** the silicon solar cell is first provided with the emitter layer, the contact grid and a rear contact, and the contact grid is electrically connected to one pole of a voltage source, and that a contacting device that is electrically connected to the other pole of the voltage source is connected to the rear contact, and, with the voltage source, a voltage is applied directed contrary to the forward direction of the silicon solar cell that is less than the breakdown voltage of the silicon solar cell, and, when applying this voltage, a point light source is guided over the sun-facing side of the silicon solar cell and thereby a section of a subsection of the sun-facing side is illuminated and thus a current flow is induced in the subsection where the current flow relative to the section has a current density of 200 A/cm² to 20,000 A/cm² and acts on the subsection for 10 ns to 10 ms, except for a current density resulting from a current flow in the range of 100 mA and a laser spot size of 60 µm at an exposure time resulting from a laser feed rate of 10 m/s.

2. Method according to claim 1, **characterized in that** the point light source is a laser, a light-emitting diode or a flash lamp.

3. Method according to claim 1, **characterized in that** the point light source demonstrates a power density of 500 W/cm² to 200,000 W/cm² on the section.

4. Method according to claim 1, **characterized in that** the point light source emits radiation with a wavelength in the range from 400 nm to 1500 nm.

5. Method according to claim 1, **characterized in that** the section has an area in the range from 10³ µm² to 10⁴ µm².

6. Method according to claim 1, **characterized in that** the voltage directed against the forward direction of the silicon solar cell is in the range from 1 V to 20 V.

7. Method according to claim 1, **characterized in**
**that** the point light source is guided directly next to the contact fingers of the contact grid on the sun-facing side of the silicon solar cell.

8. Method according to claim 1, **characterized in that** the silicon solar cell is monofacial or bifacial.

9. Method according to claim 1, **characterized in that** the silicon solar cell comprises of an n- or p-doped silicon substrate.

10. Method according to claim 1, **characterized in that** the emitter layer has a sheet resistance of more than 100 Ω/sq.

## Revendications

1. Procédé visant à améliorer le comportement de contact ohmique entre une grille de contact et une couche émettrice d'une cellule photovoltaïque au silicium, **caractérisé en ce que** la cellule photovoltaïque au silicium est d'abord prévue avec la couche émettrice, la grille de contact et un contact arrière et **en ce que** la grille de contact est raccordée électriquement à un pôle d'une source d'alimentation et **en ce qu'**un dispositif de contact raccordé électriquement à l'autre pôle de la source d'alimentation est relié au contact arrière, **en ce qu'**avec la source d'alimentation une tension dirigée dans le sens opposé à l'avancement de la cellule photovoltaïque au silicium, laquelle est inférieure en valeur absolue à la tension de rupture de la cellule photovoltaïque au silicium, est appliquée, et **en ce que**, lors de l'application de cette tension, une source lumineuse ponctuelle est guidée par le côté de la cellule photovoltaïque au silicium orienté vers le soleil et qu'une section d'une zone partielle du côté orienté vers le soleil est éclairée et qu'un flux de courant est induit ainsi dans la zone partielle, et **en ce que** ce flux de courant, par rapport à la section, a une densité de courant comprise entre 200 A/cm² et 20 000 A/cm² et agit sur la zone partielle pendant 10 ns à 10 ms, à l'exception d'une densité de courant résultant d'un flux de courant de l'ordre de 100 mA et d'une taille de spot laser de 60 µm pour un temps d'action résultant d'une avance laser de 10 m/s.

2. Procédé selon la revendication 1, **caractérisé en ce que**
la source lumineuse ponctuelle est un laser, une diode électroluminescente ou une lampe flash.

3. Procédé selon la revendication 1, **caractérisé en ce que** la source lumineuse ponctuelle sur la section présente une densité de puissance de 500 W/cm² à 200 000 W/cm².

4. Procédé selon la revendication 1, **caractérisé en ce que**
la source lumineuse ponctuelle émet un rayonnement d'une longueur d'onde comprise entre 400 nm et 1 500 nm.

5. Procédé selon la revendication 1, **caractérisé en ce que**
la section a une surface comprise entre 1·10³ µm² et 1·10⁴ µm².

6. Procédé selon la revendication 1, **caractérisé en ce que**
la tension dirigée dans le sens opposé à l'avancement de la cellule photovoltaïque au silicium est comprise entre 1 V et 20 V.

7. Procédé selon la revendication 1, **caractérisé en ce que**
la source lumineuse ponctuelle est guidée directement à côté des doigts de contact de la grille de contact par le côté orienté vers le soleil de la cellule photovoltaïque au silicium orienté vers le soleil.

8. Procédé selon la revendication 1, **caractérisé en ce que**
la cellule photovoltaïque au silicium est monofaciale ou bifaciale.

9. Procédé selon la revendication 1, **caractérisé en ce que**
la cellule photovoltaïque au silicium présente un substrat de silicium dopé N ou P.

10. Procédé selon la revendication 1, **caractérisé en ce que**
la couche émettrice présente une résistance de couche supérieure à 100 Ohm/sq.
